# EUROPÄISCHE PATENTSCHRIFT

(11) **EP 3 740 772 B1**
(45) Veröffentlichungstag und Bekanntmachung des Hinweises auf die Patenterteilung: **15.05.2024**
(21) Anmeldenummer: 19701308.9
(22) Anmeldetag: 15.01.2019
(51) Int. Cl.: G01R 31/34

(54) **VERFAHREN ZUM TEST VON BRÜCKEN EINER ENDSTUFE BEI DREHENDER MASCHINE**
METHOD FOR TESTING BRIDGES OF AN END STAGE IN A ROTATING MACHINE
PROCÉDÉ DE TEST DE PONTS D'UN ÉTAGE FINAL DANS UNE MACHINE TOURNANTE

(30) Priorität: 17.01.2018 DE 102018200717
(43) Veröffentlichungstag der Anmeldung: 25.11.2020
(73) Patentinhaber: Robert Bosch GmbH, 70442 Stuttgart (DE)
(72) Erfinder: SCHILLER, Uwe, 74372 Sersheim (DE); HIRY, Pascal, 71665 Vaihingen/Enz (DE); KURFISS, Jochen, 75417 Lomersheim (DE)
(86) Internationale Anmeldenummer: PCT/EP2019/050882
(87) Internationale Veröffentlichungsnummer: WO 2019/141657

(56) Entgegenhaltungen:
- EP-A2- 0 981 056
- DE-A1- 19 851 186
- DE-A1-102014 108 637
- DE-A1-102017 106 181
- GB-A- 2 350 946
- US-A- 5 627 758
- US-A1- 2006 038 517
- US-A1- 2008 309 274

## Beschreibung

Die vorliegende Erfindung betrifft ein Verfahren zum Test von Brücken einer einen Mikrocontroller, eine erste Brückenschaltung und eine zweite Brückenschaltung umfassenden Endstufe bei drehender Maschine, umfassend die Verfahrensschritte: Feststellen einer Drehzahl einer mittels der Brückenschaltungen der Endstufe betriebenen Maschine durch den Mikrocontroller, und Durchführen eines Low SpeedTests, falls die festgestellte Drehzahl einen vordefinierten Schwellwert nicht überschreitet oder Durchführen einer Beobachtung von für die Brücken vorgesehenen Treibern, falls die festgestellte Drehzahl dem vordefinierten Schwellwert entspricht oder diesen überschreitet.

### Stand der Technik

Heute verfügbare Konzepte für Antriebsinverter in der Leistungsklasse bis 15 kW bei einer Versorgungsspannung unterhalb der Berührspannungsgrenze von 60 V setzen zur Vermeidung eines sogenannten Thermal Incidents (TI) in unterschiedlichen Applikationen Endstufentests in B6-Brückenschaltungen ein.

Dabei wird während des Betriebs mithilfe einer Drain-Source-Überwachung das Verhalten eines Metall-Oxid-Halbleiter-Feldeffekttransistors (metal-oxidesemiconductor field-effect transistor, MOSFET) permanent überwacht. Im Rahmen dessen erfolgt permanent eine Detektion auf einen Querkurzschluss innerhalb einer Halbbrücke mittels einer sogenannten Short Circuit Detection (SCD), welche eine Auslöseschwelle von ungefähr dem 2,5-fachen des maximalen Nennstroms im Scheitelwert aufweist und bei welcher die Drain-Source-Spannung mithilfe eines Komparators überwacht wird. Überschreitet die Drain-Source-Spannung bei einem eingeschalteten MOSFET die zuvor eingestellte und auch als Short Circuit Detection Level (SCDL) bezeichnete Schwelle, so wird die Endstufe innerhalb von weniger als 5 µs abgeschaltet, um größere Schäden zu vermeiden.

Aufgrund der sehr starken Temperaturabhängigkeit des Durchgangswiderstands R_{DS(on)} des MOSFET und dessen Aufbau- und Verbindungstechnik (AVT) liegt die Auslöseschwelle bei dem 2,5-fachen des maximal im Betrieb möglichen Stroms. Diese Funktion eignet sich folglich nur als geeignete Maßnahme, um einen Thermal Incident in letzter Sekunde zu vermeiden.

Zudem hat eine permanente Überwachung zur Folge, dass sich bei einem auftretenden Querkurzschluss und dessen Detektierung aufgrund der Reaktions-, Filter- und Schaltzeit der Endstufe ein deutlich größerer Querstrom ergeben kann. Dieser deutlich größere Querstrom führt dazu, dass die Zwischenkreisspannung unter bestimmten Voraussetzungen so weit zusammenbrechen kann, dass die hiermit versorgte Logik in einen Unterspannungs-Reset geht. Beim Neustart des Systems kennt die Logik den zuvor noch bekannten Fehler nicht mehr, da sie vor dem Neustart zeitlich nicht mehr in der Lage war, den detektierten Fehler im elektrisch löschbaren programmierbaren Nur-Lese-Speicher (electrically erasable programmable readonly memory, EEPROM) abzulegen. Aus diesem Grund wird die Logik beim Wiederaktivieren der Endstufen denselben Querkurzschluss erfahren. Schlimmstenfalls entsteht hierdurch ein Deadlock, der in der Folge zu einem Thermal Incident führen kann.

Um ein derartiges Verhalten zu vermeiden, wird gemäß Stand der Technik in mehreren Antriebskonzepten - wie beispielsweise bei elektrischen Servolenkungen (ESL), E-Bikes, Boost-Rekuperations-Maschine (BRM) und integrierten Startergeneratoren (ISG) - beim Aufstarten ein Brückentest durchgeführt. Dieser Brückentest versucht frühzeitige Fehler in den Endstufen sowie auch als Isolationsfehler in den Maschinen auftretende Fehlfunktionen zu erkennen, indem die Detektionsschwelle im mA-Bereich liegt. Nachteilig ist bei einem derartigen Low SpeedTest (auch als Leckstromtest oder Fehlerstromtest bezeichnet) jedoch, dass dieser keine Differenzspannung zwischen den Phasensignalen berücksichtigt. In Abhängigkeit von der Maschinentopologie - beispielsweise bei permanent erregten Synchronmaschinen (PSM) oder elektrisch erregten Synchronmaschinen (ESM) - ist mitunter eine blockierte, feststehende, nicht drehende Maschine erforderlich. Dies trifft auch auf die vorgenannten Antriebskonzepte zu.

Da ein herkömmlicher Anlasser auf dem 12V-Bordnetz eines Kraftfahrzeugs zuerst den Verbrenner startet und erst danach die 48V-Batterie zugeschaltet wird, wird aufgrund der festen Verbindung der Boost-Rekuperations-Maschine mit der Kurbelwelle und der Anordnung von Permanentmagneten zur Magnetflusskompensation auf dem Rotor derselben eine Differenzspannung an den Phasen erzeugt. Diese Differenzspannung reicht selbst im Leerlauf dazu aus, Fehlerströme in den Endstufen nicht mehr ausreichend detektieren zu können. Das gleiche Problem existiert unter anderem auch bei einem Reset eines Mikrocontrollers im Betrieb.

Mit der gemäß dem Stand der Technik gegebenen Hardware kann ein Aufstarten des Systems unter Sicherstellung eines funktionalen Inverters daher nicht gewährleistet werden. Tritt im ausgeschalteten Zustand des Inverters ein Fehler in den Endstufen oder in den Windungen der Maschine gegenüber dem Gehäuse auf, so wird ein solcher Fehler beim Aufstarten nicht frühzeitig erkannt. Auch ist es derzeit nicht möglich, dass nach einem Reset des Steuergeräts ein Aufstarten des Systems ohne vorheriges Abstellen des Motors erfolgen kann. Auch im Falle eines vorliegenden Deadlocks kann beim Aufstarten des Systems ein zuvor ausgelöster Brückenkurzschluss nicht unterbrochen werden. Zudem ist eine Erkennung von temperaturabhängigen Defekten in MOSFET - beispielsweise kann ein MOSFET bei 175°C einen Schluss beziehungsweise Durchbruch haben, der gleiche nach einem Neustart auf 120°C abgekühlte MOSFET jedoch nur erhöhte Fehlerströme aufweisen - derzeit nicht zuverlässig möglich.

Das Dokument EP 0 981 056 A2 beschreibt ein Verfahren zur Ermittlung des Pumpenzustands.

Das Dokument DE 10 2017 106181 A1 offenbart einen Störungstest für eine Transistorbrücke.

### Offenbarung der Erfindung

Erfindungsgemäß wird ein Verfahren gemäß Anspruch 1 zum Test von Brücken einer einen Mikrocontroller, eine erste Brückenschaltung und eine zweite Brückenschaltung umfassenden Endstufe bei drehender Maschine zur Verfügung gestellt, welches die Verfahrensschritte
- Feststellen einer Drehzahl einer mittels der Brückenschaltungen der Endstufe betriebenen Maschine durch den Mikrocontroller, und
- Durchführen eines Low SpeedTests, falls die festgestellte Drehzahl einen vordefinierten Schwellwert nicht überschreitet oder Durchführen einer Beobachtung von für die Brücken vorgesehenen Treibern, falls die festgestellte Drehzahl dem vordefinierten Schwellwert entspricht oder diesen überschreitet,
umfasst.

Dabei nutzt das erfindungsgemäße Verfahren für die Fehlererkennung der Endstufe und der Maschine vorhandene Hardware-Elemente. Damit ist für die bereits im sogenannten C-Muster befindliche Hardware kein Re-Design notwendig. Zudem wird auf der sogenannten Low Temperature Cofired Ceramics (LTCC) kein weiterer Platz für zusätzliche Bauelemente benötigt. Mit dem erfindungsgemäßen Konzept wird die im Brückentreiber integrierte Funktionalität zur Erkennung des Zustandes der Endstufen im sogenannten PreDrive ohne aktives Einschalten der Endstufen genutzt.

### Vorteile der Erfindung

Das erfindungsgemäße Verfahren hat den Vorteil, dass dadurch erreicht wird, dass nach einem Reset des Steuergeräts ein Aufstarten des Systems ohne vorheriges Abstellen des Motors stattfinden kann. Der Aufstart des Systems unterbricht zudem einen Deadlock bei einem zuvor ausgelösten Brückenkurzschluss. Des Weiteren sind erfindungsgemäß auch die Entdeckung von temperaturabhängigen Defekten bei MOSFET sowie die Entdeckung von schleichenden frühzeitigen Isolationsdefekten von Maschinenwindungen und des Bürsten-Schleifringsystems eines Rotors möglich.

In einer bevorzugten Ausgestaltung der Erfindung ist vorgesehen, dass beim Durchführen des Low SpeedTests ein Test der High Side-Schalter der ersten Brückenschaltung, ein Test der High Side-Schalter der zweiten Brückenschaltung, ein Test der Low Side-Schalter der ersten Brückenschaltung und ein Test der Low Side-Schalter der zweiten Brückenschaltung erfolgen. Durch solch einen Low SpeedTest kann sichergestellt werden, dass eine Aussage über den Zustand aller Schalter, insbesondere MOSFET, getroffen werden kann, da die jeweiligen High Side-Schalter beziehungsweise Low Side-Schalter über die Verbindung der Motorphasen parallel zueinander liegen.

Vorteilhafterweise ist nach Durchführen des Low SpeedTests eine Prüfung der für die Brücken vorgesehenen Treiber auf Kommunikationsfehler, Abschaltpfade und Funktion vorgesehen. Auf diese Weise wird mittels eines derartigen Treibertests nicht nur eine Funktion der Brückenschaltungen an sich, sondern auch eine Gesamtfunktionalität gewährleistet.

Gemäß einer bevorzugten Ausführungsform der Erfindung ist vorgesehen, dass das Testen der High Side-Schalter der ersten Brückenschaltung und/oder der High Side-Schalter der zweiten Brückenschaltung erfolgt, indem mithilfe der Zwischenkreisspannungsmessung und der Phasenspannungsmessung an einer ersten Phase eine Differenzspannung bestimmt wird (Passivtest). In analoger Weise ist vorteilhafterweise vorgesehen, dass das Testen der Low Side-Schalter der ersten Brückenschaltung und/oder der Low Side-Schalter der zweiten Brückenschaltung erfolgt, indem an einer zweiten Phase eine stromlimitierte Spannungsquelle angelegt wird, sodass das Spannungspotential an den Phasen angehoben wird (Aktivtest). Dadurch kann jeweils eine Aussage über alle High Side- und Low Side-Schalter beziehungsweise MOSFET getroffen werden.

Bevorzugter Weise umfasst das Durchführen der Beobachtung von für die Brücken vorgesehenen Treibern einen Test der Low Side-Schalter der zweiten Brückenschaltung, einen Test der High Side-Schalter der zweiten Brückenschaltung, eine Messung der Zeit einer elektrischen Periode des Maschinendrehfeldes der Maschine mittels einer Rotorlagesensorik, und eine Konfiguration der für die Brücken vorgesehenen Treiber durch den Mikrocontroller. Mittels eines derartigen High SpeedTests (auch als TLE Observer Test oder Beobachtertest bezeichnet) wird erreicht, dass jede Phase beziehungsweise jeder Schalter separat gemessen und beobachtet werden kann, obwohl aufgrund der gegebenen hohen Drehzahl der Maschine die Differenzspannung zwischen den Phasen zu groß ist, um eine Spannungsrücklesung an einer Phase sicher für alle Endstufen durchführen zu können.

Gemäß einer bevorzugten Ausführungsform der Erfindung ist vorgesehen, dass eine zyklische Messung der Drain-Source-Spannung für jeden der als MOSFET ausgebildeten Schalter der ersten Brückenschaltung und/oder der zweiten Brückenschaltung innerhalb einer elektrischen Umdrehung der Maschine erfolgt, wobei die gemessenen Werte vorteilhafterweise in einem Speicher abgelegt werden. Pro elektrischer Umdrehung werden dabei beispielsweise 20 Messwerte pro FET abgelegt.

Vorteilhafterweise erfolgt nach erfolgter Messung eine Auswertung der für als MOSFET ausgebildeten Schalter erfassten Werte der Drain-Source-Spannung. Dadurch kann insbesondere mittels einer Fallunterscheidung analysiert werden, ob die als MOSFET ausgebildeten Schalter als gut deklariert werden können oder ob sie als defekt einzustufen sind und keine Pulsweitenmodulation (PWM)-Freigabe erfolgen darf.

Vorteilhafte Weiterbildungen der Erfindung sind in den Unteransprüchen angegeben und in der Beschreibung beschrieben.

### Zeichnungen

Ausführungsbeispiele der Erfindung werden anhand der Zeichnungen und der nachfolgenden Beschreibung näher erläutert. Es zeigen:
Figur 1 das Aufstartverhalten einer Boost-Rekuperations-Maschine gemäß dem Stand der Technik,
Figur 2 eine schematische Darstellung der Hardware-Elemente des Brückentestes im PreDrive,
Figur 3 eine detaillierte Darstellung der Hardware-Elemente von MOSFET bis zum Brückentreiber,
Figur 4 in einem UML-Diagramm den Ablauf eines erfindungsgemäßen Brückentests bei drehender Maschine in vereinfachter Form,
Figur 5 in einem UML-Diagramm den Ablauf eines erfindungsgemäßen Brückentests bei drehender Maschine in ausführlicher Form, und
Figur 6 eine schematische Darstellung eines "Key On"-Zyklus und in diesem mögliche Testzeitpunkte zur Anwendung des erfindungsgemäßen Verfahrens.

### Ausführungsformen der Erfindung

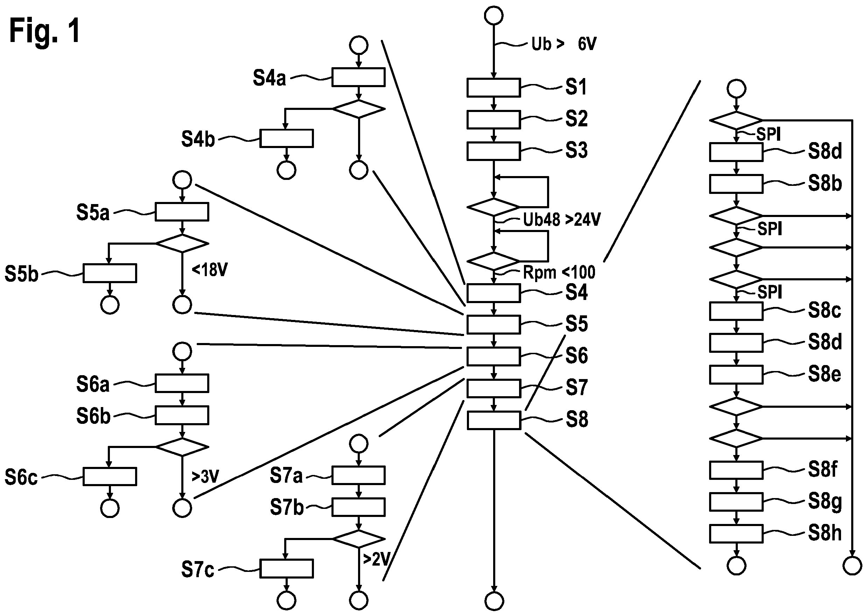

In Figur 1 ist in einem Ablaufdiagramm das Aufstartverhalten beziehungsweise die Initialisierung einer Boost-Rekuperations-Maschine (BRM) gemäß dem Stand der Technik dargestellt. Nachdem die Betriebsspannung U_{b} den Wert von 6 Volt überschritten hat, erfolgt in Schritt S1 der Hochlauf der anwendungsspezifischen integrierten Schaltung (application-specific integrated circuit, ASIC) des Systems sowie ein Selbsttest desselben. Anschließend läuft in Schritt S2 der Mikrocontroller hoch, in der Kernlogik implementierte Selbsttests (built-in self tests; BIST) werden durchgeführt und Ports konfiguriert. In Schritt S3 erfolgt ein Test des ASIC des Systems sowie der entsprechenden Konfiguration. Nach Durchführung der Schritte S1 bis S3 wird geprüft, ob die Betriebsspannung U_{b48} den Wert von 24 Volt überschritten hat. Ist dies der Fall, so wird als Nächstes geprüft, ob die Drehzahl einen Wert von 100 Umdrehungen pro Minute (rounds per minute, rpm) noch nicht überschritten hat.

Falls auch diese Bedingung erfüllt ist, wird in Schritt S4 der Brückentest für die High Side (HS)-Schalter der B10-Brückenschaltung vorgenommen (B10 Passivtest), wozu in Schritt S4a zunächst die Werte der Spannungen U_{48Vslow} und Uₚₕₓ eingelesen werden und anschließend die Spannungsdifferenz ermittelt wird. Ist diese Spannungsdifferenz größer als 2 Volt, so kann daraus abgeleitet werden, dass die HS-Schalter der B10-Brückenschaltung in Ordnung sind. Falls jedoch lediglich eine Differenz von 2 Volt oder kleiner gegeben ist, so wird in Schritt S4b festgestellt, dass ein zu hoher Fehlerstrom vorliegt. Daraus lässt sich schließen, dass die HS-Schalter der B10-Brückenschaltung defekt sind, sodass die BRM in den sogenannten Safe Inverter State zu setzen ist.

In Schritt S5 erfolgt anschließend der Brückentest für die HS-Schalter der B4-Brückenschaltung (B4 Passivtest), bei welcher gemäß Schritt S5a zunächst die Spannung U_{FSn} gemessen wird. Ist diese Spannung kleiner als 18 Volt, so bedeutet dies, dass die HS-Schalter der B4-Brückenschaltung in Ordnung sind. Falls jedoch ein Spannungswert von 18 Volt oder mehr vorliegt, so bedeutet dies, dass entweder HS-Schalter der B4-Brückenschaltung defekt sind und die BRM in den Safe Inverter State zu setzen ist wie in Schritt S5b erkennbar ist.

In Schritt S6 schließt sich der Brückentest für die Low Side (LS)-Schalter der B10-Brückenschaltung an, bei welchem in Schritt S6a zunächst die stromlimitierte 11V/10mA-Spannungsquelle über den System-ASIC an die Phase U angelegt wird (B10 Aktivtest). Anschließend findet in Schritt S6b eine Messung der Spannung Uₚₕₓ statt. Ergibt diese Messung gemäß Schritt S6c einen Wert größer als 3 Volt, so bedeutet dies, dass die LS-Schalter der B10-Brückenschaltung in Ordnung sind. Anderenfalls sind zu hohe Fehlerströme gegeben, sodass entweder LS-Schalter der B10-Brückenschaltung oder die gegen das Massepotential aufweisende Gehäuse eingesetzte EM-Isolierung defekt sind und die BRM in den Safe Inverter State zu setzen ist.

In Schritt S7 erfolgt danach der Brückentest für die LS-Schalter der B4-Brückenschaltung, bei welchem in Schritt S7a zunächst die stromlimitierte 11 V/10mA-Spannungsquelle vom System-ASIC über den Mikrocontroller zum FSn zugeschaltet wird (B4 Aktivtest). Anschließend erfolgt eine Messung der Spannung U_{FSn} in Schritt S7b, wobei ein gemessener Spannungswert von mehr als 2 Volt bedeutet, dass die LS-Schalter der B4-Brückenschaltung in Ordnung sind. Ist dies nicht der Fall, so sind zu hohe Fehlerströme gegeben, was gemäß Schritt S7c darauf schließen lässt, dass entweder LS-Schalter der B4-Brückenschaltung oder EM-Isolierung gegenüber dem Gehäuse defekt sind und die BRM in den Safe Inverter State zu setzen ist.

In Schritt S8 erfolgt zuletzt der Brückentreibertest für die Brückenschaltungen B4 und B10, bei welchem zunächst die Funktion des Serial Peripheral Interface (SPI) getestet wird. Ist keine Kommunikation über das SPI möglich, so erfolgt ein Übergang in den Safe Inverter State und eine Freigabe erfolgt nicht. Bei positivem Testresultat erfolgt in Schritt S8a ein Einschalten der Brückentreiber und in Schritt S8b die Durchführung von Bugfixing, Workarounds und Diagnosen. Anschließend wird erneut ein Test der SPI-Kommunikation durchgeführt und bei negativen Testergebnis der Safe Inverter State und keine Freigabe initiiert. Bei positivem Testergebnis wird hingegen der INH-Abschaltpfad via µC_SysASIC getestet und bei erfolgreichem Resultat dieses Tests erneut die SPI-Kommunikation geprüft. Anschließend wird in Schritt S8c der Brückentreiber eingeschaltet, in Schritt S8d Bugfixing, Workaround und Diagnosen durchgeführt und in Schritt S8e eine Konfiguration des Brückentreibers TLE durchgeführt. Daran schließt sich der Selbsttest für den TLE, die Spannung Vcc sowie Operationsverstärker an, bevor ein Testen der Abschaltpfade ENA, S_{OFF} und INH vorgenommen werden kann. Bei positiver Durchführung desselben erfolgt in Schritt S8f ein Einschalten der Brückentreiber, in Schritt S8g die Durchführung von Bugfixing, Workarounds und Diagnosen sowie in Schritt S8h die Konfiguration des TLE, sodass letztendlich eine PWM-Freigabe erfolgen kann.

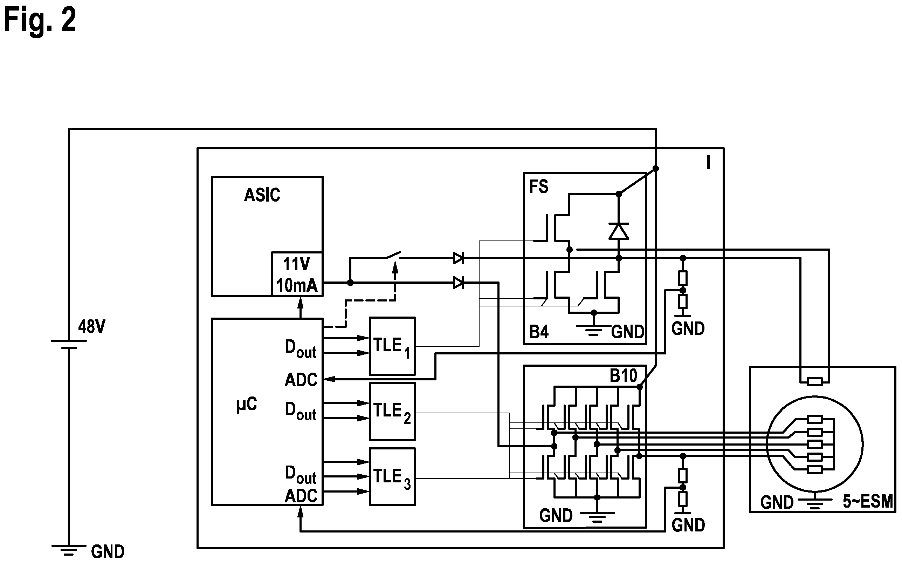

In Figur 2 ist eine schematische Darstellung der Hardware-Elemente des Brückentestes im PreDrive gezeigt, welche eine 48V-Batterie, eine stromlimitierte (10mA) Spannungsquelle (11V) innerhalb des System ASICs, eine B4-Brückenschaltung, eine B10-Brückenschaltung, einen Mikrocontroller µC, mehrere Brückentreiber, sowie einen Verbraucher 5~ ESM aufweist. Der Mikrocontroller µC ist zum Empfang analoger Signale ausgebildet, welche er an den Eingängen ADC als analoge Signale empfängt und mittels Analog-Digital-Konverter in digitale Signale umwandeln kann. Zudem ist der Mikrocontroller µC zur Ausgabe von digitalen Steuersignalen über die Ausgänge D_{OUT} ausgebildet.

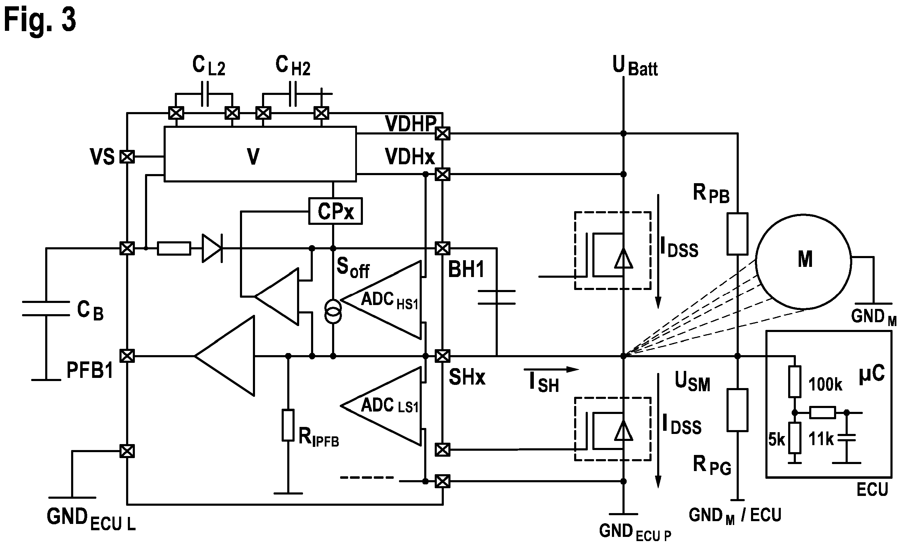

In Figur 3 ist eine detaillierte Darstellung der Hardware-Elemente von MOSFET bis zum Brückentreiber gegeben. Entsprechend der vorliegenden Erfindung ist ein eine Software umfassender Mikrocontroller µC vorgesehen, welcher eine Beobachtung der Spannungssignale über eine elektrische Periode vornimmt. Ferner ist erfindungsgemäß eine Sensorik vorgesehen, welche im Brückentreiber eine A/D-Wandlung der direkt an der Endstufe sensierten Spannung U_{ds} vornehmen kann.

Der gemäß dem vorliegenden Ausführungsbeispiel verwendete Brückentreiber TLE9180 beinhaltet eine Drain-Source-Spannungsmessung, die mittels einer SPI-Schnittstelle vom Mikrocontroller µC aus zu gezielten Messpunkten gemessen werden kann. Dabei erfolgt die digitale Übertragung des gemessenen Messwertes im Spannungsfenster von -1,45 bis +1,45 V über die SPI-Schnittstelle mit einer Auflösung von 8 Bit. Ursprünglich war die vorgenannte Messeinheit dazu gedacht, eine Temperaturmessung der Endstufen auf Basis des temperaturabhängigen R_{DS(on)} des MOSFET darstellen zu können.

Um eine Endstufe nun bei jedem Neustart bereits vor dem Einschalten zu testen, wird in Abhängigkeit der Drehzahl der Maschine M bei Drehzahlen kleiner als der Schwellwert von beispielsweise 100 Umdrehungen pro Minute (rounds per minute, rpm) eine reine Fehlerstrommessung gemäß dem Stand der Technik vorgenommen. Alternativ wird hingegen bei Drehzahlen, welche dem Schwellwert von 100 Umdrehungen pro Minute entsprechen oder diesen überschreiten, eine Beobachtung der Drain-Source-Spannungen mithilfe des Brückentreibers durchgeführt. Der Wert von 100 Umdrehungen pro Minute ist dabei abhängig von der Maschine, in welcher je nach Rotormagnetfeld je Umdrehung pro Minute eine Spannung zwischen den Phasen induziert wird. Ist diese Spannung zu groß, kann nicht mehr mit einer gemeinsamen Phasenspannungsmessung für alle Phasen an einer einzelnen Phase gemessen werden, da es aufgrund der Differenzspannungen zu Fehldiagnosen kommen kann.

Für den ersten Fall, dass eine Drehzahl von weniger als 100 rpm vorliegt und der sogenannte Low SpeedTest Anwendung findet, werden zunächst die High Side-MOSFET der Brücke B10 getestet, indem mithilfe der Zwischenkreisspannungsmessung und der Phasenspannungsmessung an der ersten Phase X die Differenzspannung bestimmt wird. Somit erhält man nun - solange keine Differenzspannung zwischen den Phasen anliegt - eine Aussage über alle High Side-MOSFET der Brücke B10, da diese dann parallel liegen. Da die erste Phase X über einen gegen den Massepunkt GND angebundenen Spannungsteiler zur Sensierung angebunden ist, wird sich im Normalfall ein Spannungspegel mit 0 V am ADC messen lassen. Hat ein High Side-MOSFET oder eine Phase gegen 12 V oder 48 V nun einen Fehlerschluss, so ergibt sich eine erhöhte Spannung am A/D-Wandler. Liegt die Differenzspannung zwischen U_{dc} und Phase X nun bei kleiner 2 V, so wird von einem Defekt der Endstufen an der High Side ausgegangen, wobei je nach Spannung unterschiedliche Sensitivitäten zu erkennen sind, so dass der Wert von kleiner als 2 V als Beispielwert anzusehen ist. Andernfalls wird die Endstufe als funktionsfähig beziehungsweise in Ordnung quittiert und der nächste Schritt getestet.

Anschließend werden die High Side-(MOS)FET der Brücke B4 getestet. Hier existiert ein weiterer Spannungsteiler gegen GND, wie insbesondere aus Figur 2 entnehmbar ist. Eine Messung wird in analoger Weise zu der für die High Side-MOSFET der Brücke B10 beschriebenen Messung durchgeführt.

Danach werden die Low Side-(MOS)FET der Brücke B10 getestet, indem an die Phase U - beispielhaft gemäß dem Ausführungsbeispiel - eine stromlimitierte Spannungsquelle des System-ASICs (11 V/10 mA) angelegt wird, wodurch das Spannungspotential an den Phasen angehoben wird. Durch Einlesen der Spannung an der Phase U kann nun detektiert werden, ob sich ein Fehlerstrom über die Low Side-(MOS)FET oder über eine Verbindung der Statorwicklungen zum Maschinengehäuse GND ausgebildet hat. Liegt die Spannung hier bei weniger als 2 V, so liegt ein Defekt vor. Anderenfalls ist ein Defekt nicht gegeben und eine Funktionsfähigkeit liegt vor. Demnach kann davon ausgegangen werden, dass beim Einschalten eines MOSFET kein Batteriekurzschluss und somit auch kein Thermal Incident entstehen.

Als letzten Endstufentest werden nun die Low Side-(MOS)FET der Brücke B4 gemessen, indem die entsprechend dem Ausführungsbeispiel eingesetzte stromlimitierte Spannungsquelle des System-ASIC nun zusätzlich an den Feldsteller gelegt wird. Eine Messung wird in analoger Weise zu der für die Low Side-(MOS)FET der Brücke B10 beschriebenen Messung durchgeführt.

Anschließend wird der Brückentreiber auf Kommunikationsfehler, Abschaltpfade und Funktion geprüft.

Im zweiten Fall, dem sogenannten High SpeedTest, in welchem eine Drehzahl von 100 rpm oder mehr vorliegt, ist die Differenzspannung zwischen den einzelnen Phasen zu groß, sodass über die Spannungsrücklesung an einer Phase nicht mehr sicher erkannt werden kann, ob sich Fehlerströme ausgebildet haben oder nicht. Daher ist es in diesem Fall erforderlich, jede Phase beziehungsweise jeden MOSFET separat zu messen und zu beobachten, wie nachfolgend beschrieben wird. Ist eine Differenzspannung vorhanden, so kann ein defekter MOSFET an beispielsweise X oder V nicht über die Spannungsmessung an U detektiert werden. In umgekehrter Weise wird ein fehlerhafter MOSFET detektiert, da aufgrund der induzierten Spannung zwischen den Phasen und dem über die im MOSFET vorhandenen Inversdioden fließenden Strom eine zu kleine Spannung an U erkannt wird. Je nach Position der Messung innerhalb der elektrischen Periode kann das eine oder andere auftreten.

Im Anschluss daran wird über die Rotorlagesensorik die Zeit einer elektrischen Periode des Maschinendrehfeldes gemessen. Die Periodendauer liegt bei einem Beispiel BRM mit 8 Polpaaren und einer maximalen Drehzahl von 20000 Umdrehungen pro Minute je nach Drehzahl bei maximal 370 µs. Für die B10-Brücke wird ferner die Testspannung aktiviert, um einen Potentialunterschied zwischen Phasen und GND, sowie U_{b48V} und Phase zu erreichen, und die Messergebnisse - zumindest im kleineren Drehzahlbereich - zu verbessern

Der Brückentreiber wird nun über die SPI-Schnittstelle vom Mikrocontroller µC so konfiguriert, dass er ohne Aktivierung der Endstufen eine Überwachung dieser durchführen kann (sogenannter TestMode).

Die Drain-Source-Spannung wird nun an jedem MOSFET innerhalb einer elektrischen Umdrehung in äquidistanten Zeitschritten mehrmals gemessen und die gemessenen Werte im Speicher abgelegt. Der Brückentreiber ist dabei in der Lage die Drain-Source-Spannung in einem Bereich von -1,45 V bis +1,45 V zu messen. Auf Basis dieser Messdaten kann ein kurzgeschlossener FET detektiert werden. Die Messung erfolgt in Zeitschritten von mindestens 32 µs, welche für die Messung und Übertragung benötigt werden. Dabei werden immer die 3 HS FET oder die 3 LS FET eines Brückentreibers ausgelesen.

Somit ergibt sich je nach Drehzahl eine unterschiedlich tiefe Abtastung auf Basis der elektrischen Umdrehung. Pro elektrischer Umdrehung werden vorliegend immer 20 Messwerte gemessen, um die Verarbeitung und den Speichergehalt zu optimieren. Das heißt, je nach Drehzahl ist die Pausenzeit zwischen den Messungen unterschiedlich. Gegebenenfalls ist eine Drehzahlunterscheidung vorzunehmen, sodass beispielsweise bei Drehzahlen größer als 10.000 rpm mehrere Perioden gemessen werden.

Nach erfolgter Messung werden die Daten ausgewertet, was mithilfe einer Fallunterscheidung erfolgt. Liegen beispielsweise mehr als 30 % der Messwerte eines MOSFET bei Werten größer als 1,4 V, so wird der MOSFET als gut deklariert. Damit wird auch der Betrieb innerhalb der negativen Halbwelle - bei dem der FET in der Diode ist - erkannt und gemessen. Dies muss bei den 20 Messwerten berücksichtigt werden. Anderenfalls wird der MOSFET als defekt eingestuft, und es erfolgt keine PWM-Freigabe.

Des Weiteren ist vorgesehen, dass drehzahlunabhängig alle LSbeziehungsweise alle HS-Messwerte gemeinsam betrachtet werden. Liegt ein Fehler eines einzelnen LS-MOSFET vor, so fließt in den anderen LS-MOSFET zwangsweise auch ein Strom über die Inversdioden, sodass auch dort die Anzahl der Messwerte größer als 1,45 V - also mit positiver Drain Source Spannung - reduziert ist.

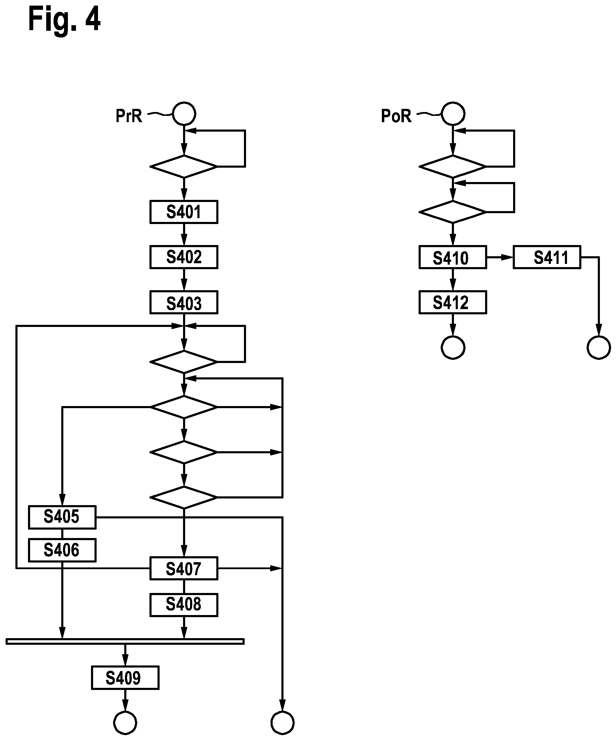

Figur 4 zeigt in einem UML-Diagramm den Ablauf eines erfindungsgemäßen Brückentests bei drehender Maschine in vereinfachter Form. Dabei wird in einem auf der linken Seite gemäß Figur 4 dargestellen PreRun-Test PrR zunächst geprüft, ob die Spannung U_{b12V} den Wert von 6 V überschritten hat. Ist dies der Fall, so erfolgt in Schritt S401 ein Startup des System-ASIC mit Supply und Seiftest. Anschließend läuft in Schritt S402 der Mikrocontroller hoch, in der Kernlogik implementierte Selbsttests (built-in self tests; BIST) werden durchgeführt und Ports konfiguriert. In Schritt S403 erfolgt ein Test des ASIC des Systems sowie der entsprechenden Konfiguration.

Nach Durchführung der Schritte S401 bis S403 wird geprüft, ob die Betriebsspannung U_{b48} den Wert im Bereich von 24 bis 54 Volt liegt. Ist dies der Fall, so wird als Nächstes im rpm-Test geprüft, ob die Drehzahl in einem Bereich von 100 bis 10000 Umdrehungen pro Minute (rounds per minute, rpm) liegt. Falls die Drehzahl kleiner als 100 rpm ist, so erfolgt in Schritt S405 eine Low Speed-Messung/-Test mit einem anschließenden Setzen des Zählers für "Low SpeedTest" auf den Wert 0 in Schritt S406.

Falls die Drehzahl jedoch im Bereich von 100 bis 10000 rpm liegt, so wird anschließend geprüft, ob ein Eintrag für ein "bridge failure" vorliegt. Falls dies so ist, wird der vorgenannte rpm-Test erneut durchgeführt. Anderenfalls wird anschließend überprüft, ob bereits ein Low SpeedTest entsprechend Schritt S405 durchgeführt wurde, was anhand des gesetzten Zählers auswertbar ist. Wurde ein solcher Test noch nicht durchgeführt, so wird auch hier der vorgenannte rpm-Test erneut durchgeführt.

Falls ein Low SpeedTest bereits absolviert wurde, wird in Schritt S407 der High SpeedTest durchgeführt. Falls der High SpeedTest nicht erfolgreich durchgeführt werden konnte und ungültige Daten erhalten wurden, wird der vorgenannte rpm-Test erneut durchgeführt. Bei erfolgreicher Durchführung des High SpeedTests wird anschließend in Schritt S408 der Zähler für "Low SpeedTest done" inkrementiert. Wird ein Fehler erkannt, so wird der Safe Inverter State aktiviert. In Schritt S409 erfolgt nachfolgend der Bridgedriver-Test, unabhängig davon, ob lediglich ein Low SpeedTest oder ein High SpeedTest durchgeführt wurden, mit anschließender Aktivierung des "Idle Mode".

Im rechts in Figur 4 dargestellten PostRun-Test PoR erfolgt zunächst eine Überprüfung, ob die Spannung U_{b48} größer als 24 Volt ist. Sobald dies der Fall ist, wird geprüft, ob die Drehzahl bereits kleiner als 100 Umdrehungen pro Minute ist. Ist auch diese Bedingung erfüllt, so wird in Schritt S410 der Low SpeedTest durchgeführt, nach dessen Beendigung in Schritt S411 gegebenenfalls ein Eintrag für einen defekten FET in Schritt S411 gesetzt und in den Safe Inverter State eingetreten wird. Alternativ wird ohne erkannten Fehler in Schritt S412 der Zähler für "Low SpeedTest done" auf 0 gesetzt und eine Nachricht zur Abschaltung der Batterie mittels CAN versendet.

Durch den anhand von Figur 4 dargestellten Ablauf soll sichergestellt werden, dass für jeden zweiten KeyOn-Zyklus ein Low SpeedTest durchgeführt wird. Ist im PreRun kein Low SpeedTest möglich, so muss im PostRun ein Low SpeedTest erzwungen werden.

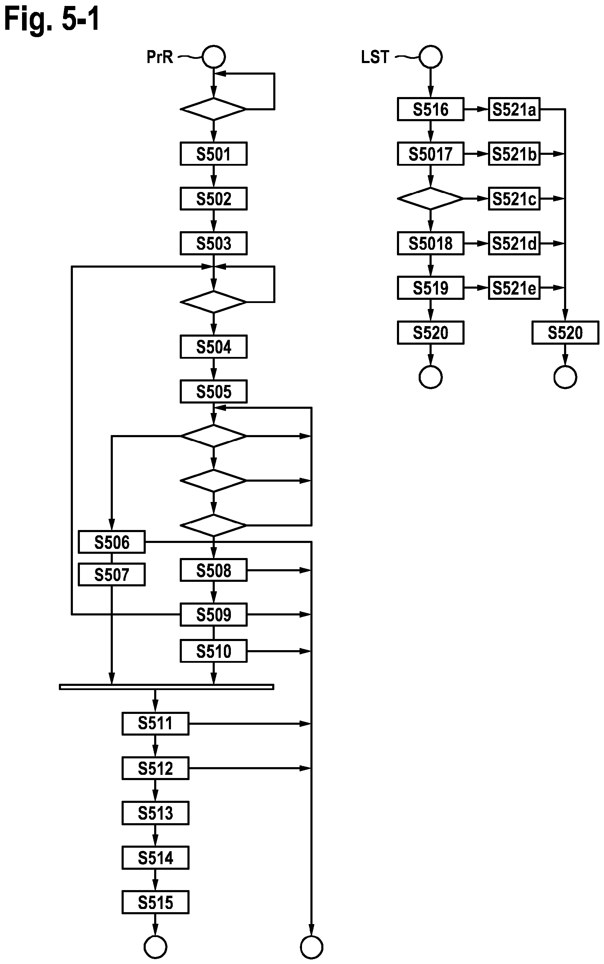

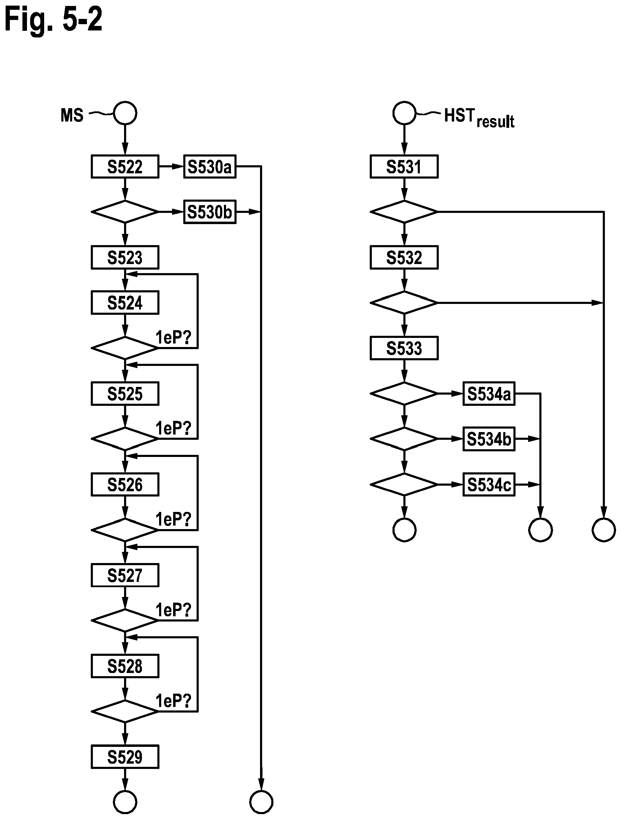

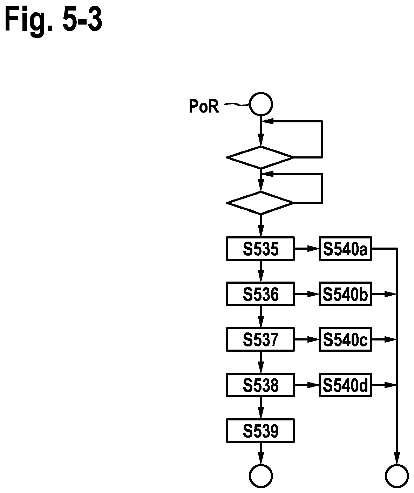

Figur 5 zeigt in einem UML-Diagramm den Ablauf eines erfindungsgemäßen Brückentests bei drehender Maschine in ausführlicher Form. Dabei wird im PreRun-Test PrR zunächst überprüft, ob die Spannung U_{b12V} den Wert von 6 Volt überschritten hat. Ist dies der Fall, so erfolgt in Schritt S501 ein Startup des System-ASIC mit Supply und Seiftest. Anschließend läuft in Schritt S502 der Mikrocontroller hoch, in der Kernlogik implementierte Selbsttests (built-in self tests; BIST) werden durchgeführt und Ports konfiguriert. In Schritt S503 erfolgt ein Test des ASIC des Systems sowie der entsprechenden Konfiguration.

Danach wird überprüft, ob die Spannung Ub48slow einen Wert zwischen 24 und 54 Volt angenommen hat. Falls dem so ist, werden in den Schritten S504 und S505 die Werte für "Ub48Vinit measurement" und "Rpm_init measurement" gespeichert.

Als Nächstes wird im rpm-Test geprüft, ob die Drehzahl in einem Bereich von 100 bis 15000 Umdrehungen pro Minute (rounds per minute, rpm) liegt. Falls die Drehzahl kleiner als 100 rpm ist, so erfolgt in Schritt S506 eine Low Speed-Messung/-Test mit einem anschließenden Setzen des Zählers für "Low SpeedTest" auf den Wert 0 in Schritt S507. Falls die Drehzahl jedoch im Bereich von 1000 bis 15000 rpm liegt, so wird anschließend geprüft, ob ein Eintrag für ein "bridge failure" vorliegt. Falls dies so ist, wird der vorgenannte rpm-Test erneut durchgeführt. Anderenfalls wird anschließend überprüft, ob bereits ein Low SpeedTest entsprechend Schritt S506 durchgeführt wurde, was anhand des gesetzten Zählers auswertbar ist. Wurde ein solcher Test noch nicht durchgeführt, so wird auch hier der vorgenannte rpm-Test erneut durchgeführt.

Falls ein Low SpeedTest bereits absolviert wurde, wird in Schritt S508 der High SpeedTest durchgeführt. Nach Durchführen des High SpeedTest wird bei erkanntem Fehler der Safe Inverter State aktiviert und zudem in Schritt S509 mittels "TLE observer data result decision" geprüft, ob die während des High SpeedTest erhaltenen Daten gültig sind. Wurden ungültige Daten erhalten, wird der Verfahrensablauf ab dem vorgenannten rpm-Test erneut durchgeführt. Bei erfolgreicher Durchführung des High SpeedTests ohne erkannten Fehler wird anschließend in Schritt S510 der Zähler für "Low SpeedTest done" inkrementiert. Mittels Rücksetzen des Zählers "Low SpeedTest done" wird nach durchgeführtem Test sichergestellt, dass ein erneutes Aufstarten im PreRun bei drehender Maschine erfolgen kann. Bei erkanntem Fehler wird der Safe Inverter State eingeleitet. Danach wird in den Schritten S511 bis S515 der Brückentreiber auf Fehler überprüft. Danach kann der "Drive Mode" aktiviert werden.

Der weiterhin in Figur 5 dargestellte Low SpeedTest LST beginnt in Schritt S516 mit dem Passivtest der High Side B10-Brücken. Falls die gemessene Spannung U_{48vslow}-Uₚₕₓ größer als 2 Volt ist, wird in Schritt S517 mit dem High Side-Passivest der B4-Brücken fortgefahren, anderenfalls wird in Schritt S521a ein Eintrag für einen Defekt in den HS FET B10-Brücken erzeugt und der Safe Inverter State aufgerufen.

Im Passivtest der High Side B4-Brücken in Schritt S517 wird gemessen, ob die Spannung U_{FSn} kleiner als 18 Volt ist. Ist dies nicht der Fall, wird in Schritt S521b ein Eintrag für einen Defekt in den HS FET B4-Brücken erzeugt und der Safe Inverter State aufgerufen.

Anderenfalls fährt das Verfahren mit einem Test der TLE SPI Kommunikation vor. Bei negativem Testergebnis hierfür wird in Schritt S521c ein Eintrag für einen Defekt in der SPI-Kommunikation erzeugt und der Safe Inverter State aufgerufen.

Anderenfalls erfolgt in Schritt S518 der Aktivtest der Low Side B10-Brücken, gemäß welchem überprüft wird, ob die Spannung Uₚₕₓ größer als 3 Volt ist. Ist dies nicht der Fall, so wird in Schritt S521d ein Eintrag für einen Defekt in den LS FET B10-Brücken erzeugt und der Safe Inverter State aufgerufen.

Falls die Spannung Uₚₕₓ größer als 3 Volt ist, so wird im Aktivtest der Low Side B4-Brücken in Schritt S519 gemessen, ob die Spannung U_{FSn} größer als 2 Volt ist. Ist dies nicht der Fall, so wird in Schritt S521e ein Eintrag für einen Defekt in den LS FET B4-Brücken erzeugt und der Safe Inverter State aufgerufen. Ansonsten wird in Schritt S520 eine Deaktivierung von CP, CP_RY und FS_TST vorgenommen. In Folge wird im Hauptprogramm der Treiber getestet und die Endstufen werden freigegeben.

Weiterhin ist in Figur 5 der High SpeedTest HS gezeigt, welcher entsprechend Schritt S522 mit einem Passivtest der High Side B4-Brücken beginnt, in welchem überprüft wird, ob die Spannung U_{FSn} kleiner als 18 Volt ist. Ist dies nicht der Fall, so wird in Schritt S530a ein Eintrag für einen Defekt in den HS FET B4-Brücken erzeugt und der Safe Inverter State aufgerufen.

Anderenfalls erfolgt ein Test der SPI-Kommunikation des TLE. Bei negativem Testergebnis hierfür wird in Schritt S530b ein Eintrag für einen Defekt in der SPI-Kommunikation erzeugt und der Safe Inverter State aufgerufen. Falls dieser Test bestanden wird, so erfolgt in Schritt S523 eine Aktivierung der stromlimitierten 11V/10mA-Spannungsquelle, eine Berechnung der zu messenden Zeit sowie eine Konfiguration des TLE im Testmodus.

In Schritt S524 erfolgt das zyklische Messen der U_{DS}-Spannung der LS MOSFET der B4 Brücke an TLE3. Die Messwerte werden innerhalb einer elektrischen Periode beispielsweise zwanzig Mal gemessen und im RAM abgelegt.

In Schritt S525 erfolgt das zyklische Lesen via SPI-Verbindung und Abspeichern der Spannung U_{DS} aller drei High Side FET von TLE1 im RAM solange bis eine elektrische Periode gemessen wurde, vorliegend insgesamt jeweils zwanzig Mal.

In Schritt S526 erfolgt das zyklische Lesen via SPI-Verbindung und Abspeichern der Spannung U_{DS} aller drei Low Side FET von TLE1 im RAM solange bis eine elektrische Periode gemessen wurde, vorliegend insgesamt jeweils zwanzig Mal.

In Schritt S527 erfolgt das zyklische Lesen via SPI-Verbindung und Abspeichern der Spannung U_{DS} aller drei High Side FET von TLE2 im RAM solange bis eine elektrische Periode gemessen wurde, vorliegend insgesamt jeweils zwanzig Mal.

In Schritt S528 erfolgt das zyklische Lesen via SPI-Verbindung und Abspeichern der Spannung U_{DS} aller drei Low Side FET von TLE2 im RAM solange bis eine elektrische Periode gemessen wurde, vorliegend insgesamt jeweils zwanzig Mal.

Abschließend wird in Schritt S529 eine Deaktivierung der stromlimitierten 11V/10mA-Spannungsquelle vorgenommen.

Weiter zeigt Figur 5 den Ablauf hinsichtlich der Entscheidung über die erhaltenen Ergebnisdaten des High SpeedTests.

In Schritt S531 werden die Werte für Ub48V_calc sowie Rpm_calc gemessen und die Werte für Ub48=(Ub48V_init + Ub48V_calc)/2 sowie Ub48V diff=abs(Ub48V_init- Ub48V_calc) berechnet. Ist der Wert Ub48V_diff größer als 5 Volt, so liegt eine ungültige Messung vor und eine Wiederholung der Messung muss erfolgen. Dementsprechend wird in Schritt S531 nach erfolgtem Datensammeln der einzelnen Drain-Source-Spannungen die Drehzahl und die angelegte DC-Spannung erneut gemessen und in Folge der Unterschied zwischen der Eingangsmessung und der Mittelwert beider Messungen berechnet. Ist die Differenz zwischen Eingangs- und Endmessung zu groß, so muss der Test wiederholt werden, da mitunter keine gesamte elektrische Periode gemessen wird, und somit keine plausiblen Daten vorliegen. Auch bei einer zu großen Abweichung der DC-Spannung während des Datensammelns muss der Test wiederholt werden.

Falls der Wert Ub48V_diff kleiner als 5 Volt ist, erfolgt in Schritt S532 die Berechnung der Drehzahl mit Rpm=(Rpm_init + Rpm_calc)/2 sowie von Rpm_diff=abs(Rpm_init - Rpm_calc). Ist der Wert von Rpm_diff größer als 100 Umdrehungen pro Minute, so liegt eine ungültige Messung vor und eine Wiederholung der Messung muss erfolgen.

Im Schritt S533 erfolgt die Auswertung der gesammelten Messdaten der Drain-Source-Spannungen. Hier werden alle Messdaten der 5 Phasen der LS FET, beziehungsweise alle 5 HS FET sowie die der beiden LS FET des Feldstellers jeweils gemeinsam bewertet. Liegt ein Schluss eines HS FET der B10 Brücke vor, so wird mithilfe der Inversdioden aller anderen HS FET der B10 ein zyklischer Phasenkurzschluss erzeugt, welcher dazu führt, dass die Summe der positiven Drain-Source-Spannungen deutlich reduziert wird. Äquivalent gilt dies auch für den LS MOSFET der B10 Brücke, sowie die LS FET der B4 Brücke der Rotorwicklung. Somit kann über die Anzahl der Messdaten aller LS (A_LS_over_14V) beziehungsweise HS FET (A_HS_over_14V) der B10 Brücke, beziehungsweise alternativ der LS FET der B4 Brücke, welche größer beispielsweise 1,4V liegen, eine Entscheidung getroffen werden, ob sich ein Fehler in den LS FET oder in den HS FET der B10 oder der B4 Brücke befindet.

Da die induzierte Spannung der Maschine an der B10 Brücke beziehungsweise den Statorwindungen jedoch in manchen Bereichen größer ist als die angelegte DC-Spannung, und folglich die Inversdioden auch bei funktionsfähigen FET teilweise im leitfähigen Bereich sind, kann mithilfe eines Verhältnis (HSQuot_over_14 V) von Anzahl der Messungen, welche größer als beispielsweise 1,4 V am HS zur Anzahl der Messungen, welche größer als beispielsweise 1,4 V am LS sind, eine Verbesserung der Erkennung in Grenzbereichen erfolgen.

Der Schwellwert (LimitQuot_Over_14 V) für den Vergleich über die Anzahl der Messungen wird vorteilhafterweise über eine DC-Spannungs- und Drehzahlmatrix vorgegeben. Je nach Verhältnis der induzierten Spannung zu angelegter DC Spannung verschiebt sich die Schwelle aufgrund des teilweise auftretenden Betriebs über die Inversdioden. Alternativ kann auch mit einer fixen Schwelle je nach Drehzahl und angelegter DC-Spannung ein unterschiedlicher Fehlerwiderstand erkannt werden.

Die induzierte Spannung an der Rotorwicklung der fremderregten Maschine ist deutlich geringer, daher wird an dieser Baugruppe auf das Verhältnis verzichtet. Zudem erfolgt aus Gründen der Messzeitreduzierung eine Messung der HS FET mithilfe des passiven Low SpeedTests. Der Schwellwert wird als fixer Parameter (Limit_A_FS_LS_14V) vorgegeben.

Danach erfolgt eine Überprüfung, ob A_FS_LS_14V größer als Limit_A_FS_LS_14V ist. Falls dies nicht so ist, so wird in Schritt S534a ein Eintrag für einen Defekt in den LS FET B4-Brücken erzeugt und der Safe Inverter State aufgerufen.

Falls A_FS_LS_14V jedoch größer als Limit_A_FS_LS_14V ist, erfolgt eine Überprüfung, ob HSQuot_over_14V größer als LimitQuot_over_14V ist. Falls dies nicht so ist, so wird in Schritt S534b ein Eintrag für einen Defekt in den HS FET erzeugt und der Safe Inverter State aufgerufen.

Falls HSQuot_over_14V größer als LimitQuot_over_14V ist, erfolgt eine Überprüfung, ob LSQuot_over_14V größer als LimitQuot_over_14V ist. Falls dies nicht so ist, so wird in Schritt S534c ein Eintrag für einen Defekt in den LS FET erzeugt und der Safe Inverter State aufgerufen.

Des Weiteren ist in Figur 5 das PostRun-Szenario PoR dargestellt, wobei im PostRun bei stehender Maschine ein Low SpeedTest durchgeführt wird, um innerhalb eines KeyOn-Zyklus eine genaue Fehlerdiagnose zu erreichen. Der Low SpeedTest mittels Fehlerstromüberwachung besitzt eine erhöhte Sensibilität gegenüber Fehlerwiderständen. Dabei erfolgt entsprechend Figur 5 zunächst eine Überprüfung, ob die Spannung U_{b48} größer als 24 Volt ist. Sobald dies der Fall ist, wird geprüft, ob die Drehzahl bereits kleiner als 100 Umdrehungen pro Minute ist. Ist auch diese Bedingung erfüllt, so wird in Schritt S535 der Passivtest der High Side B10-Brücken durchgeführt und gemessen, ob die Drain-Source-Spannung der HS FET (48Vslow - Uphx) größer als 2 Volt ist. Ist dies nicht der Fall, so wird in Schritt S540a ein Eintrag für einen Defekt in den HS FET B10-Brücken erzeugt und der Safe Inverter State aufgerufen.

Falls jedoch 48Vslow - Uphx größer als 2 Volt ist, wird in Schritt S536 mit dem Passivtest der High Side B4-Brücken fortgefahren und gemessen, ob U_{FSn} kleiner als 18 Volt ist. Ist dies nicht der Fall, so wird in Schritt S540b ein Eintrag für einen Defekt in den HS FET B4-Brücken erzeugt und der Safe Inverter State aufgerufen.

Anderenfalls wird in Schritt S537 mit dem Aktivtest der Low Side B10-Brücken fortgefahren und gemessen, indem die externe stromlimitierte 11V/10mA-Spannungsquelle aktiviert wird und eine Messung erfolgt, ob Uₚₕₓ größer als 3 Volt ist. Ist dies nicht der Fall, so wird in Schritt S540c ein Eintrag für einen Defekt in den LS FET B10-Brücken erzeugt und der Safe Inverter State aufgerufen.

Falls jedoch Uₚₕₓ größer als 3 Volt ist, wird in Schritt S538 mit dem Aktivtest der Low Side B4-Brücken fortgefahren, CP_RY_FS aktiviert und gemessen, ob U_{FSn} größer als 2 Volt ist. Ist dies nicht der Fall, so wird in Schritt S540d ein Eintrag für einen Defekt in den LS FET B4-Brücken erzeugt und der Safe Inverter State aufgerufen.

Anderenfalls wird letztendlich in Schritt S539 der Zähler für den Low SpeedTest auf 0 gesetzt und der Verfahrensablauf beendet.

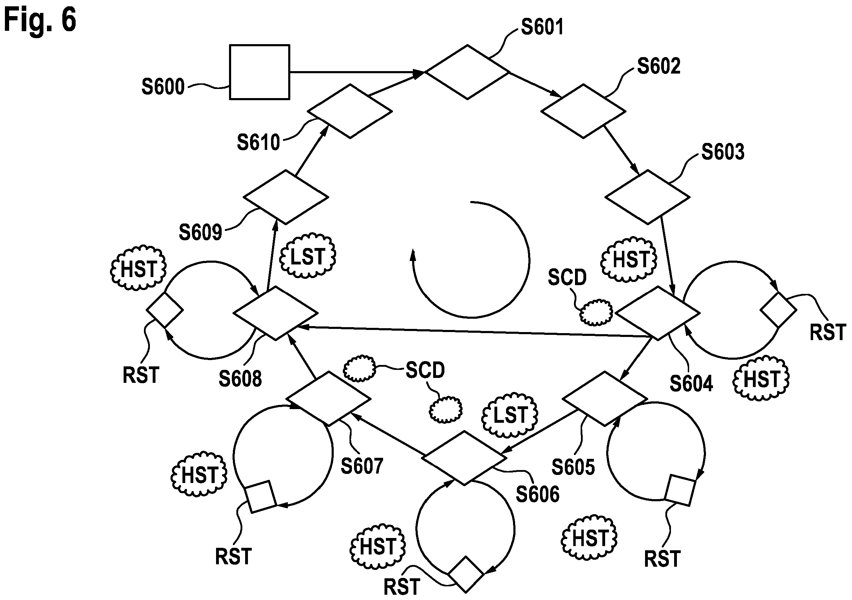

In Figur 6 ist in einer schematischen Darstellung ein "Key On"-Zyklus beziehungsweise Lebenszyklus mit in diesem möglichen Testzeitpunkten dargestellt. Daran ist insbesondere erkennbar, dass mit dem erfindungsgemäßen Verfahren in einem Produktlebenszyklus nun an verschiedenen Stellen Brückentests durchgeführt werden können, um einen sogenannten Thermal Incident zu verhindern. Da die einzelnen Tests - wie Low SpeedTest und High SpeedTest- unterschiedliche Erkennungsschwellen von Endstufenfehlern aufweisen, ist eine regelmäßige Überprüfung im Betrieb empfehlenswert.

Nachdem ein Inverter in Schritt S600 einen Fertigungsprozess inklusive Transport und Lagerung durchlaufen hat, wird in Schritt S601 über Klemme 15 eines Kraftfahrzeugs die 12V-Versorgung des Inverters sichergestellt. Danach erfolgt in Schritt S602 der Erststart des Inverters mit 12 V und 2.000 Umdrehungen pro Minute. Anschließend wird in Schritt S603 die 48 V-Batterie zugeschaltet. An dieser Stelle bietet sich die Durchführung des High SpeedTests an, bevor in Schritt S604 eine PWM-Freigabe erfolgt und der sogenannte Run Mode gestartet wird. Zudem bietet sich die Durchführung des High SpeedTests auch während des Run Modes nach einem Reset an.

In Schritt S605 bietet sich bei Stoppen des Verbrennungsmotors eines Kraftfahrzeugs - beispielsweise aufgrund einer StartStop-Automatik oder im Modus des Segelns, bei welchem das Getriebe selbstständig in den Leerlauf schaltet, sobald der Fahrer vom Gas geht - nach einem Reset ebenfalls die Möglichkeit eines High SpeedTests.

Bevor der Verbrennungsmotor in Schritt S606 wieder gestartet wird, kann hingegen der Low SpeedTest durchgeführt werden, wobei beim Startvorgang des Verbrennungsmotors die Short Circuit Detection (SCD) zum Einsatz kommen kann und nach einem Reset während des Startvorgangs wiederum ein High SpeedTest denkbar ist.

In Schritt S607 schließt sich der bereits unter Schritt S604 beschriebene Run Mode an, in dessen Rahmen erneut ein High SpeedTest durchgeführt werden könnte.

Schritt S608 stellt den Fall dar, dass bei Ausschalten der Zündung über Klemme 15 der Verbrennungsmotor gestoppt wird, wobei dieser Zustand ebenfalls auch ausgehend von Schritt S604 erreicht werden kann, was durch den in Figur 6 dargestellten Pfeil erkennbar ist. Nach dem aus diesem Zustand resultierenden Reset ist ebenfalls die Durchführung des High SpeedTests sinnvoll.

Vor Ausschalten der 48V-Versorgung in Schritt S609, an welche sich ein Ausschalten der 12V-Versorgung mittels Klemme 87 in Schritt S610 anschließt, ist hingegen wieder die Durchführung eines Low SpeedTests denkbar.

Beim sogenannten High SpeedTest ist eine Erkennungstiefe von etwa 20 bis 50 Ohm gegeben, wobei die Randbedingung eines sich im TestMode befindenden Brückentreibers TLE erfüllt sein muss. Beim Low SpeedTest ist eine Erkennungstiefe von bis zu 100 Ohm gegeben, wobei als Randbedingung eine Drehzahl von weniger als 100 rpm, eine ausgeschaltete PWM sowie ein ausgeschalteter Brückentreiber TLE erfüllt sein müssen. Bei der aus dem Stand der Technik bekannten Short Circuit Detection ist hingegen lediglich eine Erkennungstiefe von weniger als 0,005 Ohm gegeben.

Weiter besteht die Möglichkeit einer Plausibilisierung der Messung, indem die Drain-Source-Spannungen beider MOSFET innerhalb einer Halbbrücke ausgelesen werden. Misst man beispielsweise am High Side-MOSFET über eine oder mehrere Umdrehungen zu größer als 95 % nur die maximal messbare Spannung des Brückentreibers (vorliegend 1,45 V), so kann damit ein Defekt des Low Side-(MOS)FET ebenso detektiert werden, da sich die Spannung bei anliegender Versorgungsspannung innerhalb der Halbbrücke auf beide Halbbrücken verteilen muss.

## Patentansprüche

1. Verfahren zum Test von Brücken einer einen Mikrocontroller (µC), eine erste Brückenschaltung (B10) und eine zweite Brückenschaltung (B4) umfassenden Endstufe bei drehender Maschine (M), umfassend die Verfahrensschritte:
- Feststellen einer Drehzahl einer mittels der Brückenschaltungen der Endstufe betriebenen Maschine durch den Mikrocontroller (µC), und
- Durchführen eines Low SpeedTests, falls die festgestellte Drehzahl einen vordefinierten Schwellwert nicht überschreitet, oder Durchführen einer Beobachtung von für die Brücken vorgesehenen Treibern, falls die festgestellte Drehzahl dem vordefinierten Schwellwert entspricht oder diesen überschreitet.

2. Verfahren nach Anspruch 1, wobei das Durchführen des Low SpeedTests folgende Verfahrensschritte umfasst:
- Testen der High Side-Schalter der ersten Brückenschaltung (B10),
- Testen der High Side-Schalter der zweiten Brückenschaltung (B4),
- Testen der Low Side-Schalter der ersten Brückenschaltung (B10), und
- Testen der Low Side-Schalter der zweiten Brückenschaltung (B4).

3. Verfahren nach Anspruch 1 oder Anspruch 2, wobei nach Durchführen des Low SpeedTests ferner eine Prüfung der für die Brücken vorgesehenen Treiber auf Kommunikationsfehler, Abschaltpfade und Funktion vorgesehen ist.

4. Verfahren nach einem der Ansprüche 1 bis 3, wobei das Durchführen der Beobachtung von für die Brücken vorgesehenen Treibern folgende Verfahrensschritte umfasst:
- Testen der Low Side-Schalter der zweiten Brückenschaltung (B4),
- Testen der High Side-Schalter der zweiten Brückenschaltung (B4),
- Messung der Zeit einer elektrischen Periode des Maschinendrehfeldes der Maschine mittels einer Rotorlagesensorik, und
- Konfiguration der für die Brücken vorgesehenen Treiber durch den Mikrocontroller (µC).

5. Verfahren nach Anspruch 3 oder Anspruch 4, ferner umfassend den Verfahrensschritt:
- zyklische Messung der Drain-Source-Spannung für jeden der als MOSFET ausgebildeten Schalter der ersten Brückenschaltung (B10) und/oder zweiten Brückenschaltung (B4) innerhalb einer elektrischen Umdrehung der Maschine (M).

6. Verfahren nach Anspruch 5, wobei nach erfolgter Messung eine Auswertung der für als MOSFET ausgebildeten Schalter erfassten Werte der Drain-Source-Spannung erfolgt.

7. Verfahren nach einem der Ansprüche 2 bis 6, wobei das Testen der High Side-Schalter, in Form eines Low SpeedTests, der ersten Brückenschaltung (B10) und/oder der High Side-Schalter der zweiten Brückenschaltung (B4) erfolgt, indem mithilfe der Zwischenkreisspannungsmessung und der Phasenspannungsmessung an einer ersten Phase (X) eine Differenzspannung bestimmt wird.

8. Verfahren nach einem der Ansprüche 2 bis 7, wobei das Testen der Low Side-Schalter, in Form eines Low SpeedTests, der ersten Brückenschaltung (B10) und/oder der Low Side-Schalter der zweiten Brückenschaltung (B4) erfolgt, indem an einer zweiten Phase (U) eine stromlimitierte Spannungsquelle angelegt wird, sodass das Spannungspotential an den Phasen (X, U) angehoben wird.

## Claims

1. Method for testing bridges of an output stage comprising a microcontroller (µC), a first bridge circuit (B10) and a second bridge circuit (B4) when a machine (M) is rotating, comprising the method steps of:
- determining a rotational speed of a machine operated by means of the bridge circuits of the output stage by way of the microcontroller (µC), and
- carrying out a low-speed test if the rotational speed determined does not exceed a predefined threshold value, or carrying out an observation of drivers provided for the bridges if the rotational speed determined corresponds to or exceeds the predefined threshold value.

2. Method according to Claim 1, wherein carrying out the low-speed test comprises the following method steps of:
- testing the high-side switches of the first bridge circuit (B10),
- testing the high-side switches of the second bridge circuit (B4),
- testing the low-side switches of the first bridge circuit (B10), and
- testing the low-side switches of the second bridge circuit (B4).

3. Method according to Claim 1 or Claim 2, wherein, after the low-speed test has been carried out, the drivers provided for the bridges are also checked for communication errors, switch-off paths and function.

4. Method according to one of Claims 1 to 3, wherein carrying out the observation of drivers provided for the bridges comprises the following method steps of:
- testing the low-side switches of the second bridge circuit (B4),
- testing the high-side switches of the second bridge circuit (B4),
- measuring the time of an electrical period of the rotating field of the machine by means of a rotor position sensor system, and
- configuring the drivers provided for the bridges by way of the microcontroller (µC).

5. Method according to Claim 3 or Claim 4, further comprising the method step of:
- cyclically measuring the drain-source voltage for each of the switches, which are in the form of MOSFETs, of the first bridge circuit (B10) and/or second bridge circuit (B4) within one electrical revolution of the machine (M).

6. Method according to Claim 5, wherein, following the measurement, the values of the drain-source voltage recorded for switches in the form of MOSFETs are evaluated.

7. Method according to one of Claims 2 to 6, wherein the testing of the high-side switches, in the form of a low-speed test, of the first bridge circuit (B10) and/or of the high-side switches of the second bridge circuit (B4) is effected by a differential voltage being determined with the aid of the intermediate-circuit voltage measurement and the phase voltage measurement at a first phase (X).

8. Method according to one of Claims 2 to 7, wherein the testing of the low-side switches, in the form of a low-speed test, of the first bridge circuit (B10) and/or of the low-side switches of the second bridge circuit (B4) is effected by a current-limited voltage source being applied to a second phase (U), with the result that the voltage potential at the phases (X, U) is increased.

## Revendications

1. Procédé pour tester des ponts d'un étage final comprenant un microcontrôleur (µC), un premier circuit en pont (B10) et un deuxième circuit en pont (B4), lorsque la machine (M) tourne, comprenant les étapes de procédé :
- constatation, par le microcontrôleur (µC), d'une vitesse de rotation d'une machine mise en fonctionnement au moyen des circuits en pont de l'étage final, et
- réalisation d'un test de basse vitesse dans le cas où la vitesse constatée ne dépasse pas une valeur de seuil prédéfinie, ou réalisation d'une observation de circuits d'attaque prévus pour les ponts dans le cas où la vitesse constatée est égale ou supérieure à la valeur de seuil prédéfinie.

2. Procédé selon la revendication 1, la réalisation du test de basse vitesse comprenant les étapes suivantes :
- test des commutateurs côté niveau haut du premier circuit en pont (B10),
- test des commutateurs côté niveau haut du deuxième circuit en pont (B4),
- test des commutateurs côté niveau bas du premier circuit en pont (B10), et
- test des commutateurs côté niveau bas du deuxième circuit en pont (B4).

3. Procédé selon la revendication 1 ou la revendication 2, un contrôle des circuits d'attaque prévus pour les ponts en ce qui concerne les erreurs de communication, les voies de déconnexion et le fonctionnement étant prévu après la réalisation du test à basse vitesse.

4. Procédé selon l'une des revendications 1 à 3, la réalisation de l'observation de circuits d'attaque prévus pour les ponts comprenant les étapes suivantes :
- test des commutateurs côté niveau bas du deuxième circuit en pont (B4),
- test des commutateurs côté niveau haut du deuxième circuit en pont (B4),
- mesure du temps d'une période électrique du champ tournant de machine de la machine au moyen d'un système de détection de position de rotor, et
- configuration des circuits d'attaque prévus pour les ponts par le microcontrôleur (µC).

5. Procédé selon la revendication 3 ou la revendication 4, comprenant en outre l'étape de procédé :
- mesure cyclique de la tension drain-source pour chacun des commutateurs, réalisés sous la forme de MOSFET, du premier circuit en pont (B10) et/ou du deuxième circuit en pont (B4) au sein d'un tour électrique de la machine (M).

6. Procédé selon la revendication 5, une évaluation des valeurs de la tension drain-source acquises pour les commutateurs réalisés sous la forme de MOSFET étant effectuée après avoir effectué la mesure.

7. Procédé selon l'une des revendications 2 à 6, le test des commutateurs côté haut, sous la forme d'un test de basse vitesse, du premier circuit en pont (B10) et/ou des commutateurs côté haut du deuxième circuit en pont (B4) étant effectué en déterminant une tension différentielle à l'aide de la mesure de la tension de circuit intermédiaire et de la mesure de la tension de phase sur une première phase (X).

8. Procédé selon l'une des revendications 2 à 7, le test des commutateurs côté bas, sous la forme d'un test de basse vitesse, du premier circuit en pont (B10) et/ou des commutateurs côté bas du deuxième circuit en pont (B4) étant effectué en appliquant une source de tension à limitation de courant à une deuxième phase (U), de sorte que le potentiel de tension sur les phases (X, U) soit relevé.
